Europäisches Patentamt

European Patent Office

Office européen des brevets

(11) Publication number: **0 040 275**
**B1**

(12) **EUROPEAN PATENT SPECIFICATION**

(45) Date of publication of patent specification: **20.03.85**

(21) Application number: **80301669.0**

(22) Date of filing: **20.05.80**

(51) Int. Cl.⁴: **G 01 R 19/00, H 04 N 9/47, H 03 K 5/24**

(54) **Comparison circuit adaptable for utilization in a television receiver or the like.**

(43) Date of publication of application:
**25.11.81 Bulletin 81/47**

(45) Publication of the grant of the patent:
**20.03.85 Bulletin 85/12**

(84) Designated Contracting States:
**BE DE FR IT**

(56) References cited:
**US-A-4 045 686**
**US-A-4 110 641**

(73) Proprietor: **MOTOROLA, INC.**
**1303 East Algonquin Road**
**Schaumburg, Illinois 60196 (US)**

(72) Inventor: **Gay, Michael John**
**34 rte de Bellegarde**
**1249 Chancy Geneva (CH)**

(74) Representative: **Newens, Leonard Eric et al**
**F.J. CLEVELAND & COMPANY 40/43 Chancery Lane**
**London WC2A 1JQ (GB)**

Courier Press, Leamington Spa, England.

## Description

### Background of the Invention

The present invention relates to comparison circuits suitable for fabrication in integrated circuit form and more particularly to a comparison circuit for triggering an output pulse delayed in time in response to an applied input signal obtaining a predetermined level state.

In many types of electronic systems there is a need for a comparison circuit for producing an output signal in response to an applied input signal being of a predetermined level with respect to a reference potential. An example of the need for such a comparison circuit is a Secam television chroma demodulator system wherein the chroma information is restructured in the television receiver from two successive lines of the transmitted image. In such television chroma demodulators, a line by line switch must be synchronized with the Secam signal in the correct phase to permit the foregoing. A widely used technique employs a binary divider switched by a pulse at the start of each line and set to the correct phase by an identification circuit. To obtain the correct phasing the identification circuit integrates successive identification signals provided in the received Secam signal over a period of many television lines and if the phasing is incorrect a trigger circuit is utilized for producing an identification correcting pulse for correcting the output from the binary divider.

One problem with some prior art identification circuits arises with the need to integrate the information signals over a period of many lines in order to obtain satisfactory performance with poor signal to noise ratios. Due to the extended time required for integration of the identification signals the identification correcting pulse sometimes corresponds with the divider switching period and is thus ineffective. As a result, two or more attempts at identification may be necessary in some prior art circuits.

Hence, there is a need for a comparison circuit which can produce a correction signal which can never correspond with the normal switching period of the binary divider.

### Summary of the Invention

It is an aspect of the present invention to provide an improved gated comparison circuit suitable for producing a delayed output in response to a predetermined relationship occurring between two signals applied thereto.

Another aspect of the present invention is to provide a comparison circuit having an input latching stage and which is gated on to produce an output pulse whenever the input signal has reached a predetermined level state.

Another aspect of the present invention is to provide a comparison circuit suitable for utilization in a Secam television receiver system to provide an identification correcting pulse for synchronizing the system.

A still further aspect of the invention is to provide a comparison circuit for indicating the presence of a signal of correctly identified phase.

US—A—4 110 641 which contains the features of the preamble of the present claim 1 relates to integrated circuits employing complementary metal oxide semiconductors and to a CMOS voltage comparator with internal positive current feedback for generating hysteresis in the switching of the output voltage signal as a function of the input voltage signal. The comparator includes a differential trigger pair for receiving an input signal, an output inverter circuit for switching the output between high and low voltage levels in response to the input signal and a feedback network for introducing unbalance in the differential pair to obtain hysteresis, the trigger pair being caused to switch from a first hysteresis state to a second hysteresis state in response to the input current.

In US—A—4 045 686 there is disclosed a voltage comparator circuit including a pair of time constant circuits each of which includes a variable impedance and a capacitor and each of which is controlled by a respective input voltage which are to be compared with one another, and a bistable state circuit which is stabilised to predetermined values in accordance with the comparisons effected between the time variations of the outputs of the time constant circuits. At least one of said input voltages is pulse-shaped.

According to the present invention there is provided a comparison circuit for comparing the magnitude of an applied input signal to a bias potential level including a trigger stage which receives the bias potential and has an input to receive the input signal and an output, and a feedback circuit interposed between the output and the input of the trigger stage, characterised in that the trigger stage is activated by a gating pulse applied thereto to render the feedback circuit conductive if the magnitude of the input signal is less than the bias potential level which corresponds to a first threshold level whereupon the trigger stage is latched into the activated state to cause the first threshold level to switch to a second threshold level to which the input signal is caused to be increased to, and a pulse generating circuit coupled to the trigger stage and whose output acts as the output of the comparison circuit to produce an output pulse thereat when the trigger stage is in the activated stage and the magnitude of the input signal traverses through a third threshold level, the value of the third threshold level being between the first and the second threshold levels.

Embodiments of the invention are defined in claims 2 to 8.

### Description of the Drawings

One way of carrying out the invention is described in detail below with reference to drawings which illustrate only one specific embodiment of the present invention, and in which:

FIG. 1 is a schematic diagram illustrating the embodiment of the invention; and

FIG. 2 is a timing diagram useful for explaining the operation of the invention illustrated in FIG. 1.

## Detailed Description of the Preferred Embodiment

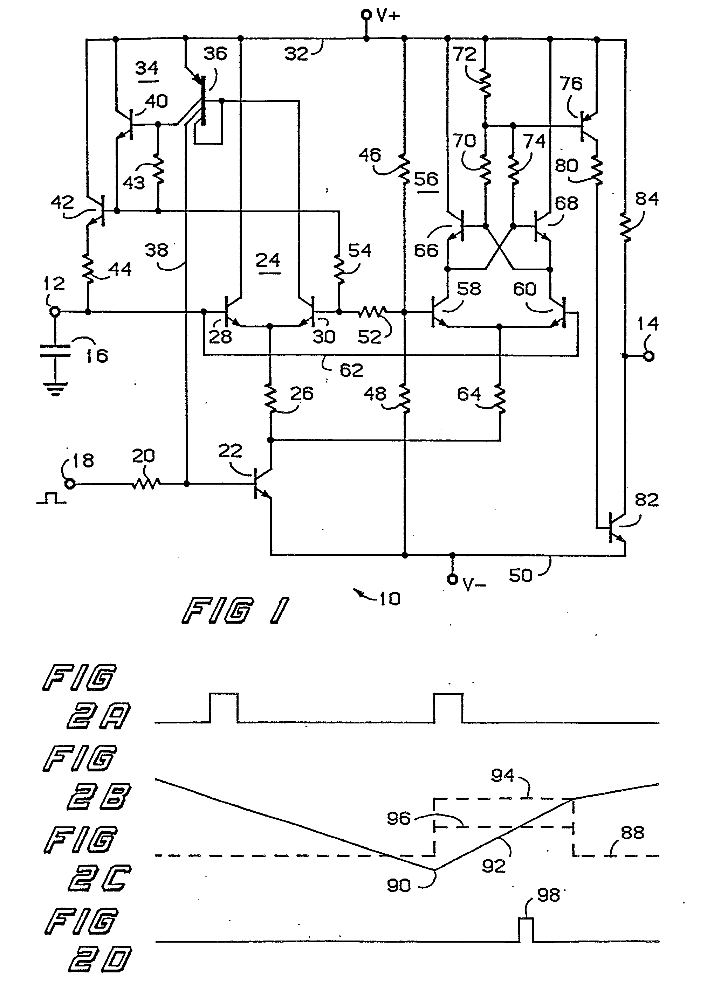

Turning to the figures, there is illustrated in FIG. 1 comparison circuit 10 of the preferred embodiment. Comparison circuit 10 is suitable to be manufactured in integrated circuit form and includes input terminal 12 and output terminal 14. Input terminal 12 is adapted to be connected to an input signal source which, in one example, may be an integrating capacitor which may have an input signal applied thereto for charging and discharging the same in accordance with a user requirement. A gating terminal 18 is adapted to receive a gating pulse as shown and is coupled through resistor 20 to the base of current source transistor 22 of differential comparator 24. The collector of current source transistor 22 is coupled through resistor 26 to the interconnected emitter electrodes of respective transistors 28 and 30 and the emitter is coupled to a terminal adapted to receive a reference potential. The base electrode of transistor 28 is coupled to input terminal 12 with the collector thereof returned to node at which a source of operating potential, V+, is supplied to power supply conductor 32. Comparison or trigger circuit 24 is activated by the gating pulses applied to terminal 18 for comparing the potential appearing at terminal 12 with a reference potential supplied at the base electrode of transistor 30. The output of comparison circuit 24 is taken at the collector of transistor 30 and is connected to an input of feedback circuit 34 which as will be explained latches comparator circuit 24 in an active state when the potential appearing across integrating capacitor 16 is at a predetermined level state. Feedback circuit 34 comprises a multicollector PNP transistor 36 the emitter thereof being coupled to power supply conductor 32. A first collector of transistor 36 is returned to the base electrode thereof, with a second collector output being coupled via lead 38 to the base electrode of current source transistor 22. A third collector output of transistor 36 is coupled to the base of transistor 40 and via resistor 43 to the emitter of transistor 40 as well as to the base of transistor 42. The junction point between resistor 43 and the base of transistor 42 is also coupled to the base of transistor 30 via resistor 54. The collector electrodes of transistors 40 and 42 respectively are returned to power supply conductor 32. The emitter of transistor 42 is returned through resistor 44 to input terminal 12. A resistor divider network comprising resistors 46 and 48 is coupled between power supply conductor 32 and a second power supply conductor 50 adapted to be coupled to a terminal at which is supplied the negative reference potential. The base electrode of transistor 30 is coupled through resistor 52 to the interconnected node between resistors 46 and 48. As will be explained, resistors 46 and 48 provide a first threshold level potential at the base of transistor 30 to which the potential appearing at terminal 12 (across integrating capacitor 16) is initially compared therewith.

A pulse generating circuit 56 including interconnected transistors 58 and 60 having respective bases coupled to the interconnected node between resistors 46 and 48 and to input terminal 12 via lead 62, respectively. The emitters of transistors 58 and 60 are interconnected through resistor 64 to the collector of current source transistor 22. The outputs of the differential amplifier comprising transistors 58 and 60 are coupled respectively to the emitter electrodes of transistors 66 and 68 which have respective collector electrodes coupled to power supply terminal 32. The base electrode of transistor 66 is coupled both to the emitter of transistor 68 as well as to power supply conductor 32 through resistors 70 and 72. The base electrode of transistor 68 is coupled both to the emitter of transistor 66 and through resistor 74 to the interconnected leads of resistors 70 and 72. A PNP transistor 76 which produces a current at the collector thereof for generating the output pulse at output terminal 14 is shown with the emitter thereof coupled to power supply conductor 32, the base being connected to the interconnected leads of resistors 70, 72 and 74. The collector of transistor 76 is coupled via resistor 80 to the base of output transistor 82. The emitter electrode of transistor 82 is coupled to power supply conductor 50 with the collector thereof coupled to output terminal 14 and through resistor 84 to power supply conductor 32.

In conjunction with FIG. 2 the operation of comparison circuit 10 can be fully explained. Comparison amplifier or trigger circuit 24 can only be rendered active in response to a gating pulse (FIG. 2A) being applied to terminal 18 which renders transistor 22 conductive. With transistor 22 conductive, current is sourced through transistors 28 and 30. If the potential appearing across capacitor 16, at terminal 12, is greater than the bias potential or first threshold level fixed by resistors 46 and 48 (level 88, FIG. 2C) transistor 30 will be rendered nonconductive with all of the current being caused to flow through transistor 28 through resistor 26 and transistor 22. In this condition the circuit does not latch. However, if the potential appearing across capacitor 16 is less than the first threshold level 88 (point 90 of waveform 2B) when the gating pulse is initiated, transistor 30 is rendered conductive and the trigger circuit will latch due to positive feedback from the transistor 40 to the base of transistor 30. In this state, with collector current being provided to transistor 30 from transistor 36, a feedback current is produced at the multiple collector outputs thereof. Transistor 40 is rendered conductive by the collector current from transistor 36 which is coupled thereto to source a first feedback current via resistor 54 to the base of transistor 30. A second feedback current conducted via lead 38 latches current source transistor 22 in an on state such that it will remain conductive when the gating pulse applied at terminal 18 is removed, as long as feedback circuit 34 is latched. During the latch state, transistor 42 is rendered conductive by the emitter current from transistor 40 to cause charging of capacitor 16 (waveform portion 92 of FIG. 2B). In response to the trigger circuit 24 being in a latched state, the bias potential appearing at the base of transistor 30 is increased to a second threshold level 94 (FIG. 2C) to which capacitor 16 will be charged. When the potential across capacitor 16 reaches the threshold level 94 trigger circuit 24 switches off regeneratively. Thus, the comparison or trigger circuit 24 will switch to the latch state for a defined period initiated by the first gating pulse applied after the potential across capacitor 16 drops below the first threshold level 88.

Pulse generating circuit 56 is rendered operational when transistor 22 is saturated by the applied gating pulse and while the trigger circuit is latched. Pulse generating circuit 56 generates an output current only when the differential voltage applied between the base electrodes of transistors 58 and 60 is substantially zero. For example, if at the initiation of a gating pulse the potential across capacitor 16 is below first threshold level 88, a large differential voltage appears across the base electrodes of transistors 58 and 60 such that transistor 58 is rendered conductive to substantially pass the whole of the current available through resistor 64. In this state, the potential appearing at base electrode of transistor 58 is represented by a third threshold level 96 (FIG. 2C). The current conducted through transistor 58 is provided both through the collector-emitter path of transistor 66 and resistors 72 and 74 respectively. The current passed through resistors 72 and 74 is just sufficient to develop a base-to-emitter voltage across resistor 74 to bring transistor 66 into conduction. Provided that resistor 72 is substantially lower than resistor 74, transistor 76 will not receive sufficient base-to-emitter voltage to be rendered conductive. The same is true if transistor 60 should be rendered conductive to pass the whole of the current available through resistor 64.

Therefore, as long as the potential across capacitor 16 remains less than the threshold level 96 transistor 76 is maintained in a nonconductive state. However, as capacitor 16 charges up to threshold level 96 the potential appearing on the bases of transistors 58 and 60 become equal so that the current available through resistor 64 is shared equally between the two collectors thereof. In this state neither transistor 66 or 68 can remain conductive and are turned off. With transistors 66 and 68 rendered nonconductive, all of the current available passes through resistor 72 to provide base drive current for transistor 76 rendering it conductive. As transistor 76 is rendered conductive a current pulse 98 is produced at the collector thereof as shown in FIG. 2D. Capacitor 16 will continue to charge to threshold level 94 at which time the feedback circuit 34 is rendered non-operative and comparison circuit 10 is no longer latched to an on condition.

As described above, comparison circuit 10 provides an output pulse delayed in time from an applied gating pulse only if the potential appearing across terminal 12 is less than the initial threshold level set by the resistor divider network comprising resistors 46 and 48. The comparison circuit will remain in a "latched on" condition until such time that the capacitor is charged by feedback circuit 34 to an "off" threshold level value at which time the comparison circuit is no longer activated.

In no way intending to limit the scope of the present invention, comparison circuit 10 could be utilized as part of the identification circuit of a television receiver adapted to receive Secam broadcast signals to provide the aforementioned identification correcting pulse to insure that the television is in synchronization with the transmitted signals. In this application, capacitor 16 would be an integrating capacitor with the potential appearing thereacross being maintained greater than the initial threshold level 88 whenever the television receiver was in correct synchronization and would be discharged below this first threshold if the television system was out of synchronization such that the pulse provided at terminal 14 could be utilized to correct the phasing in order to obtain synchronization.

The advantage of the method described above for generating output pulse 98 lies in that the pulse is delayed a predetermined time after the gating pulse is initiated which activates the trigger circuit in synchronism with the previously mentioned binary divider used for correcting the phase of the system. Hence, the correction pulse can not be initiated at the same time that the binary divider changes states. Thus, only one attempt must be made at identifying the correct phase of the incoming identification signal.

**Claims**

1. A comparison circuit (10) for comparing the magnitude of an applied input signal to a bias potential level including a trigger stage (24) which receives the bias potential and has an input (12) to receive the input signal and an output (collector of transistor 30), and a feedback circuit (34) interposed between the output and the input (12) of the trigger stage (24), characterised in that the trigger stage (24) is activated by a gating pulse applied thereto to render the feedback circuit (34) conductive if the magnitude of the input signal is less than the bias potential level which corresponds to a first threshold level (88) whereupon the trigger stage (24) is latched into the activated state to cause the first threshold level to switch to a second threshold level (94) to which the input signal is caused to be increased to, and a pulse generating circuit (56) coupled to the trigger stage (24) and whose output acts as the output (14) of the comparison circuit (10) to produce an output pulse (98) thereat when the trigger stage (24) is in the activated state and the magnitude of the input signal traverses through a third threshold level (96), the value of the third threshold level (96) being between the first and the second threshold levels (88, 94 respectively).

2. A comparison circuit as claimed in Claim 1 wherein the trigger stage (24) comprises a differential amplifier including a pair of transistors (28, 30) the emitters of which are interconnected and a current source transistor (22), the collector-to-emitter path being coupled between the interconnected emitters of said pair of transistors and a first terminal (50) adapted to receive a reference potential (V−), the base of the current source transistor (22) being adapted to receive said gating pulse to activate said differential amplifier, the base of the first one (28) of said pair of transistors being adapted to receive the input signal, the collector thereof being coupled to a second terminal (32) adapted to receive an operating potential, the base of the second one (30) of said pair of transistors being adapted to receive a first bias potential corresponding to the first threshold level and the collector thereof being the output of the trigger stage (24).

3. A comparison circuit as claimed in Claim 2 characterised by the feedback circuit (34) including a multiple collector transistor (36) of complementary type to said pair of transistors (28, 30), the emitter being coupled to said second terminal (32), a first collector thereof being connected to the base of the same and to said collector of said second transistor (30) of said pair of transistors, a second collector thereof being coupled to said base of said current source transistor (22), and a third collector being coupled both to the input (12) of the trigger stage (24) and to said base of said second transistor (30) of said pair of transistors such that the magnitude of the input signal is caused to be increased to said second threshold level (94) as the magnitude of said bias potential is changed from the first threshold level (88) to the second threshold level (94).

4. A comparison circuit as claimed in Claim 3 characterised by the feedback circuit further including a first transistor (40), the base thereof being coupled to said third collector of said multiple collector transistor (36), the collector being coupled to said second terminal (32), the emitter being coupled to said base of said second transistor (30) of said pair of transistors; and a second transistor (42), the collector thereof being coupled to said second terminal (32), the base being coupled to the emitter of said first transistor (40) of the feedback circuit, the emitter being coupled to the input (12) of the trigger stage (24), said first and second transistors (40, 42) being of complementary conductive type with respect to said multiple collector transistor (36).

5. A comparison circuit as claimed in Claim 4 characterised by its input (12) being adapted to be connected to an integrating capacitor (16) across which the input signal is developed, said second transistor (42) of the feedback circuit charging said integrating capacitor (16) when the trigger stage (24) is in said activated stage.

6. A comparison circuit as claimed in Claim 2 or 5 characterised by said pulse generating circuit (56) including a second differential amplifier including a pair of transistors (58 and 60) the emitters of which are interconnected, the interconnected emitters being coupled to said collector of said current source transistor (22), the base of the first one (58) of the second pair of transistors (58, 60) being coupled with the base of the second transistor (30) of the first pair of transistors, the base of the second one (60) of said second pair of transistors being coupled to the input (12) of the comparison circuit (10), the collectors of said respective transistors (58, 60) of said second pair of transistors being coupled to said second terminal (32).

7. A comparison circuit as claimed in Claim 6 characterised further by said pulse generating circuit (56) including a third transistor (66), the collector thereof being connected to said second terminal (32), the emitter being connected to said collector of said first transistor (58) of said second pair of transistors, the base being connected to said collector of said second transistor (60) of said second pair of transistors; a fourth transistor (68), the collector thereof being connected to said second terminal (32), the emitter being connected to said collector of said second transistor (60) of said second pair of transistors, the base being connected to said collector of said first transistor (58) of said second pair of transistors; said base of said third transistor (66) being connected through a first resistor (70) to a common node; said base of said fourth transistor (68) being coupled through a second resistor (74) to said common node; a third resistor (72) coupled between said second terminal (32) and said common node; and a fifth transistor (76) of complementary conductivity type with respect to said third (66) and fourth transistors (68), the emitter thereof being connected to said second terminal (32), the base being coupled to said common node, and the collector being coupled to the output (14) of the comparison circuit (10).

8. A comparison circuit as claimed in Claim 7 characterised by said pulse generating circuit (56) including a sixth transistor (82), the base thereof being coupled to said collector of said fifth transistor (76), the emitter being coupled to said first terminal (50), and the collector being coupled both to said second terminal (32) and the output (14) of the comparison circuit (10).

**Revendications**

1. Circuit de comparaison (10) destiné à comparer la grandeur d'un signal d'entrée appliqué à un niveau de potentiel de polarisation, comportant un étage de bascule (24) qui reçoit le potentiel de polarisation et possède une entrée (12) pour recevoir le signal d'entrée et une sortie (collecteur du transistor 30), et un circuit de réaction (34) interposé entre la sortie et l'entrée (12) de l'étage de bascule (24), caractérisé en ce que l'étage de bascule (24) est mis en activité par une impulsion de déclenchement qui lui est appliquée pour rendre le circuit de réaction (34) conducteur si la grandeur du signal d'entrée est inférieure au niveau de potentiel de polarisation qui correspond à un premier niveau de seuil (88), après quoi l'étage de bascule (24) est verrouillé à l'état d'activité pour amener le premier niveau de seuil à passer à un second niveau de seuil (94) jusqu'auquel le signal d'entrée est amené à augmenter, et un circuit générateur d'impulsions (56) couplé à l'étage de bascule (24) et dont la sortie agit en tant que sortie (14) du circuit de comparaison (10) afin d'y produire une impulsion de sortie (98) lorsque l'étage de bascule (24) se trouve à l'état actif et la grandeur du signal d'entrée passe par un troisième niveau de seuil (96), la valeur du troisième niveau de seuil (96) se situant entre les premier et second niveaux de seuil (88, 94, respectivement).

2. Circuit de comparaison suivant la revendication 1, dans lequel l'étage de bascule (24) comprend un amplificateur différentiel comprenant une paire de transistors (28, 30), dont les émetteurs sont interconnectés et un transistor de source de courant (22), le parcours de collecteur à émetteur étant couplé entre les émetteurs interconnectés de ladite paire de transistors et une première borne (50) destinée à recevoir un potentiel de référence (V−), la base du transistor de source de courant (22) étant destinée à recevoir ladite impulsion de déclenchement pour mettre en activité ledit amplificateur différentiel, la base du premier (28) des transistors de ladite paire étant destinée à recevoir le signal d'entrée, son collecteur étant couplé à une seconde borne (32) destinée à recevoir un potentiel de fonctionnement, la base du second (30) des transistors de ladite paire étant destinée à recevoir un premier potentiel de polarisation correspondant au premier niveau de seuil et son collecteur étant la sortie de l'étage de bascule (24).

3. Circuit de comparaison suivant la revendication 2, caractérisé en ce que le circuit de réaction (34) comprend un transistor à collecteurs multiples (36) de type complémentaire de ladite paire de transistors (28, 30), l'émetteur étant couplé à ladite seconde borne (32), un premier collecteur étant connecté à la base de ce transistor et audit collecteur dudit second transistor (30) de ladite paire de transistors, un second collecteur étant couplé à ladite base dudit transistor de source de courant (22), et un troisième collecteur étant couplé à la fois à l'entrée (12) de l'étage de bascule (24) et à ladite base dudit second transistor (30) de ladite paire de transistors, de telle sorte que la grandeur du signal d'entrée soit amenée à être augmentée jusqu'audit second niveau de seuil (94) alors que la grandeur dudit potentiel de polarisation est modifiée depuis le premier niveau de seuil (98) jusqu'au second niveau de seuil (94).

4. Circuit de comparaison suivant la revendication 3, caractérisé en ce que le circuit de réaction comprend en outre un premier transistor (40), dont la base est couplée audit troisième collecteur dudit transistor à collecteurs multiples (36), le collecteur étant couplé à ladite seconde borne (32), l'émetteur étant couplé à ladite base dudit second transistor (30) de ladite paire de transistors, et un second transistor (42), dont le collecteur est couplé à ladite seconde borne (32), la base étant couplée à l'émetteur dudit premier transistor (40) du circuit de réaction, l'émetteur étant couplé à l'entrée (12) de l'étage de bascule (24), lesdits premier et second transistors (40, 42) étant d'un type à conductivité complémentaire par rapport audit transistor à collecteurs multiples (36).

5. Circuit de comparaison suivant la revendication 4, caractérisé en ce que son entrée (12) est destinée à être connectée à un condensateur d'intégration (16) aux bornes duquel est engendré le signal d'entrée, ledit second transistor (42) du circuit de réaction chargeant ledit condensateur d'intégration (16) lorsque l'étage de bascule (24) se trouve dans ledit état d'activité.

6. Circuit de comparaison suivant la revendication 2 ou 5, caractérisé en ce que ledit circuit générateur d'impulsions (56) comprend un second amplificateur différentiel comprenant une paire de transistors (58 et 60), dont les émetteurs sont interconnectés, les émetteurs interconnectés étant couplés audit collecteur dudit transistor de source de courant (22), la base du premier (58) de ladite seconde paire de transistors (58, 60) étant couplée à la base du second transistor (30) de la première paire de transistors, la base du second (60) des transistors de ladite seconde paire étant couplée à l'entrée (12) du circuit de comparaison (10), les collecteurs desdits transistors respectifs (58, 60) de ladite seconde paire de transistors étant couplés à ladite seconde borne (32).

7. Circuit de comparaison suivant la revendication 6, caractérisé en outre en ce que ledit circuit générateur d'impulsions (56) comprend un troisième transistor (66), dont le collecteur est connecté à ladite seconde borne (32), l'émetteur étant connecté audit collecteur dudit premier transistor (58) de ladite seconde paire de transistors, la base étant connectée audit collecteur dudit second transistor (60) de ladite seconde paire de transistors, un quatrième transistor (68), son collecteur étant connecté à ladite seconde borne (32), l'émetteur étant connecté audit collecteur dudit second transistor (60) de ladite seconde paire de transistors, la base étant connectée audit collecteur dudit premier transistor (58) de ladite seconde paire de transistors, ladite base dudit troisième transistor (66) étant connectée par une première résistance (70) à un noeud commun, ladite base dudit quatrième transistor (68) étant couplée par une seconde résistance (74) audit noeud commun, une troisième résistance (72) couplée entre ladite seconde borne (32) et ledit noeud commun, et un cinquième transistor (76) de type de conductivité complémentaire par rapport auxdits troisième (66) et quatrième transistors (68), son émetteur étant connecté à ladite seconde borne (32), la base étant couplée audit noeud commun, et le collecteur étant couplé à la sortie (14) du circuit de comparaison (10).

8. Circuit de comparaison suivant la revendication 7, caractérisé en ce que ledit circuit générateur d'impulsions (56) comprend un sixième transistor (82), dont la base est couplée audit collecteur dudit cinquième transistor (76), l'émetteur étant couplé à ladite première borne (50) et le collecteur étant couplé à la fois à ladite seconde borne (32) et à la sortie (14) du circuit de comparaison (10).

**Patentansprüche**

1. Komparatorschaltung (10) zum Vergleichen der Größe eines zugeführten Eingangssignals mit einem Vorspannungspegel, enthaltend eine Triggerstufe (24), die die Vorspannung empfängt und einen Eingang (12) zur Aufnahme des Eingangssignals und einen Ausgang (Kollektor des Transistors 30) aufweist, und einen Rückkopplungskries (34), der zwischen den Ausgang und den Eingang (12) der Triggerstufe (24) geschaltet ist, dadurch gekennzeichnet, daß die Triggerstufe (24) durch einen ihr zugeführten Toröffnungsimpuls aktiviert wird, um den Rückkopplungskreis (34) leitend zu machen, wenn die Größe des Eingangssignals geringer ist, als der Vorspannungspegel, der einem ersten Schwellenwertpegel (88) entspricht, woraufhin die Triggerstufe (24) in den aktivierten Zustand springt, um zu bewirken, daß der erste Schwellenwertpegel auf einen zweiten Schwellenwertpegel (94) umschaltet, auf den das Eingangssignal angehoben zu werden verursacht wird, und einen Impulserzeugungskreis (56), der mit der Triggerstufe (24) verbunden ist und dessen Ausgang als Ausgang (14) der Komparatorschaltung (10) dient, um dort einen Ausgangsimpuls (98) zu erzeugen, wenn sich die Triggerstufe (24) im aktivierten Zustand befindet und die Größe des Eingangssignals einen dritten Schwellenwertpegel (96) überschreitet, wobei der Wert des dritten Schwellenwertpegels (96) zwischen dem ersten und dem zweiten Schwellenwertpegel (88 bzw. 94) liegt.

2. Komparatorschaltung nach Anspruch 1, bei der die Triggerstufe (24) einen Differenzverstärker aufweist, enthaltend ein Paar Transistoren (28, 30), deren Emitter miteinander verbunden sind, und einen Stromquellentransistor (22), dessen Kollektor-Emitter-Strecke zwischen die miteinander verbundenen Emitter des vorgenannten Transistorpaares und einen ersten Anschluß (50) geschaltet ist, der dazu eingerichtet ist, ein Bezugspotential (V—) zu empfangen, die Basis des Stromquellentransistors (22) dazu eingerichtet ist, den Toröffnungsimpuls zu empfangen, um den Differenzverstärker in Betrieb zu setzen, die Basis des ersten (28) des genannten Transistorpaares dazu eingerichtet ist, das Eingangssignal aufzunehmen, der Kollektor desselben mit einem zweiten Anschluß (32) verbunden ist, der dazu eingerichtet.ist, ein Betriebspotential zu empfangen, die Basis des zweiten (30) des genannten Transistorpaares dazu eingerichtet ist, eine erste Vorspannung zu empfangen, die dem ersten Schwellenwertpegel entspricht und dessen Kollektor der Ausgang der Triggerstufe (24) ist.

3. Komparatorschaltung nach Anspruch 2, gekennzeichnet durch einen Rückkopplungskreis (34), enthaltend einen Mehrkollektor-Transistor (36) vom zum Transistorpaar (28, 30) komplementären Typ, dessen Emitter mit dem zweiten Anschluß (32) verbunden ist, wobei ein erster Kollektor desselben mit seiner Basis und mit dem genannten Kollektor des genannten zweiten Transistors (30) des Transistorpaares verbunden ist, ein zweiter Kollektor mit der Basis des Stromquellentransistors (22) und ein dritter Kollektor mit dem Eingang (12) der Triggerstufe (24) und der genannten Basis des genannten zweiten Transistors (30) des Transistorpaares so verbunden ist, daß die Größe des Eingangssignals auf den zweiten Schwellenwertpegel (94) gesteigert zu werden verursacht wird, wenn die Größe der Vorspannung von dem ersten Schwellenwertpegel (88) auf den zweiten Schwellenwertpegel (94) verändert wird.

4. Komparatorschaltung nach Anspruch 3, dadurch gekennzeichnet, daß der Rückkopplungskreis weiterhin einen ersten Transistor (40) aufweist, dessen Basis mit dem dritten Kollektor des Mehrkollektor-Transistors (36) verbunden ist und dessen Kollektor mit dem zweiten Anschluß (32) und der Emitter mit der Basis des zweiten Transistors (30) des Transistorpaares verbunden ist, und daß er einen zweiten Transistor (42) enthält, dessen Kollektor mit dem zweiten Anschluß (32) verbunden ist, dessen Basis mit dem Emitter des ersten Transistors (40) des Rückkopplungskreises und dessen Emitter mit dem Eingang (12) der Triggerstufe (24) verbunden ist, wobei die ersten und zweiten Transistoren (40, 42) vom komplementär-leitenden Typ in Bezug auf den Mehrkollektor-Transistor (36) sind.

5. Komparatorschaltung nach Anspruch 4, dadurch gekennzeichnet, daß ihr Eingang (12) dazu eingerichtet ist, mit einem integrierenden Kondensator (16) verbunden zu werden, über dem das Eingangssignal entwickelt wird, wobei der zweite Transistor (42) des Rückkopplungskreises den integrierenden Kondensator (16) lädt, wenn die Triggerstufe (24) sich in ihrem aktivierten Zustand befindet.

6. Komparatorschaltung nach Anspruch 2 oder 5, dadurch gekennzeichnet, daß der Impulserzeugungskreis (56) einen zweiten Differenzverstärker mit einem Paar von Transistoren (58 und 60) enthält, deren Emitter miteinander verbunden sind, wobei die miteinander verbundenen Emitter mit dem Kollektor des Stromquellentransistors (22) verbunden sind, die Basis des ersten (58) des zweiten Transistorpaares (58, 60) mit der Basis des zweiten Transistors (30) des ersten Transistorpaares, die Basis des zweiten (60) des zweiten Transistorpaares mit dem Eingang (12) der Vergleichsschaltung (10), die Kollektoren der entsprechenden Transistoren (58, 60) des zweiten Transistorpaares mit dem zweiten Anschluß (32) verbunden sind.

7. Komparatorschaltung nach Anspruch 6, dadurch gekennzeichnet, daß der Impulserzeugungskreis (56) einen dritten Transistor (66) enthält, dessen Kollektor mit dem zweiten Anschluß (32), dessen Emitter mit dem Kollektor des ersten Transistors (58) des zweiten Transistorpaares, dessen Basis mit dem Kollektor des zweiten Transistors (60) des zweiten Transistorpaares verbunden sind, weiterhin einen vierten Transistor (68) enthält, dessen Kollektor mit dem zweiten Anschluß (32), dessen Emitter mit dem Kollektor des zweiten Transistors (60) des zweiten Transistorpaares, dessen Basis mit dem Kollektor des ersten Transistors (58) des zweiten Transistorpaares verbunden sind, daß die Basis des dritten Transistors (66) über einen ersten Widerstand (70) mit einem gemeinsamen Knoten verbunden ist, die Basis des vierten Transistors (68) über einen zweiten Widerstand (74) mit dem gemeinsamen Knoten verbunden ist, ein dritter Widerstand (72) zwischen den zweiten Anschluß (32) und den gemeinsamen Knoten geschaltet ist, und daß ein fünfter Transistor (76) von in Bezug auf den dritten und vierten Transistor (66 bzw. 68) komplementärer Leitfähigkeit vorhanden ist, dessen Emitter mit dem zweiten Anschluß (32), dessen Basis mit dem gemeinsamen Knoten und dessen Kollektor mit dem Ausgang (14) der Komparatorschaltung (10) verbunden sind.

8. Komparatorschaltung nach Anspruch 7, dadurch gekennzeichnet, daß der Impulsgeneratorkreis (56) einen sechsten Transistor (82) aufweist, dessen Basis mit dem Kollektor des fünften Transistors (76), dessen Emitter mit dem ersten Anschluß (50) und dessen Kollektor sowohl mit dem zweiten Anschluß (32) und dem Ausgang (14) der Komparatorschaltung (10) verbunden sind.

FIG 1

FIG 2A

FIG 2B

FIG 2C

FIG 2D